# EUROPEAN PATENT SPECIFICATION

(11) **EP 0 907 297 B1**
(45) Date of publication and mention of the grant of the patent: **07.12.2005**
(21) Application number: 97402302.0
(22) Date of filing: 01.10.1997
(51) Int. Cl.: H04Q 7/38, H03F 1/02, H03F 1/32, H04B 1/04

(54) **Communications system, network, portable device and method**
System, Netz, tragbares Gerät und Verfahren für Übertragung
Système, réseau, dispositif portable et procédé de communication

(43) Date of publication of application: 07.04.1999
(73) Proprietor: MOTOROLA SEMICONDUCTEURS S.A., 31023 Toulouse Cédex (FR)
(72) Inventor: Abdesselem, Ouelid, 31000 Toulouse (FR); Songeon, Lionel, 31170 Tournefeuille (FR); Trichet, Jacques, 31270 Cugnaux (FR)
(74) Representative: Cross, Rupert Edward Blount

(56) References cited:
- EP-A- 0 472 511
- EP-A- 0 713 300
- EP-A- 0 717 504
- WO-A-96/37053
- US-A- 4 775 995
- US-A- 5 257 283

## Description

### Field of the Invention

This invention relates to a communications system, and particularly but not exclusively to a cellular communications system.

### Background of the Invention

In a cellular communications system, a number of portable devices within a cell typically communicate with a base station of the cell via a number of channels. It is important to control the amount of unwanted 'crosstalk', or Adjacent Channel Coupled Power (ACCP or ACP) between adjacent and other channels of the same cell, and between other channels of adjacent cells, both of which cause unwanted interference.

There is a desire to increase the power efficiency of portable devices, so as to increase the available 'on' time of the devices when operating with a battery. One of the components within a portable device which has a significant impact on power consumption is the Radio Frequency (RF) power amplifier, which in portable devices must be relatively small and inexpensive.

A known problem within such RF power amplifiers is that there is a trade off between the power efficiency of the amplifier, and the linearity of the RF power amplifier. Linearity affects spectral "splattering" or spreading of the power output signal, and bad linearity has a negative effect on ACP interference.

A further problem is that with many portable devices communicating in a network, the combined ACP interference in a given channel will be high, and therefore a portable device communicating over the channel has to provide sufficient output power to distinguish itself over the ACP interference, otherwise the channel quality will suffer. This then has a knock on effect, as the higher output power of the portable device will cause a rise in interference on other channels, resulting in a cascade of power in the cell as each portable device has to overcome the ACP interference noise generated by each other portable device.

A possible solution, as described for example in European Patent application no. EP-R-0713300, is to set fixed ACP levels within the communications system, usually relative to transmitted power. This ensures that the amount of ACP interference in a channel is limited, but it also sets an upper limit on how efficiently the RF power amplifier of a portable device can be operated in each mobile unit.

US patent no. 4,775,995 discloses a method of controlling adjacent channel interference or splatter, caused by frequency or phase modulating a transmitter with analog and/or digital data, in a radio communication system.

This invention seeks to provide a communications system, network, portable device method which mitigate the above mentioned disadvantages.

### Summary of the Invention

According to the present invention there is provided and apparatus and method for dynamically controlling adjacent channel Interference as claimed in claims 1 and 4.

According to another aspect of the present invention there is provided a portable device as claimed in claim 6.

In this way a communications system is provided in which interference between channels is dynamically managed in order to achieve good power efficiency in portable devices in conjunction with good channel quality.

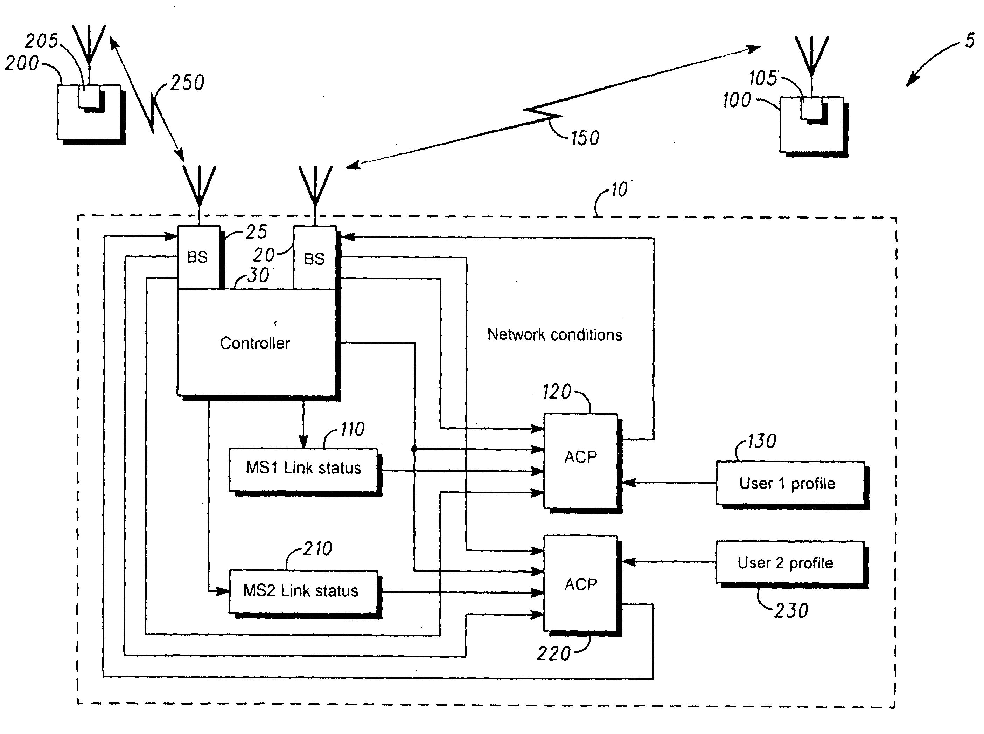

### Brief Description of the Drawing

An exemplary embodiment of the invention will now be described with reference to the single figure drawing which shows an exemplary embodiment of a communications system in accordance with the invention.

Referring to the single figure, there is shown a communications system 5, such as a Coded Digital Multiplexed Access (CDMA) cellular system. The communications system 5 including a network 10 and first and second mobile units 100 and 200 respectively.

The network 10 has a number of base stations, including the base station 20, and a further base station 25, which provide air interfaces with the first and second mobile units 100 and 200 respectively, over a plurality of radio frequency channels. The present invention may also be used in an arrangement wherein two mobiles operate in the same cell. In this case of single cell operation, the base station 20 and the base station 25 are the same.

The first mobile unit 100 has a power amplifier 105 and the second mobile unit 200 has a power amplifier 205. The power amplifiers 105 and 205 are arranged for transmitting on any selected one of the plurality of radio channels of the air interface.

The network 10 also has various infrastructure components, such as a controller 30. For illustrative purposes a number of software and hardware components of the network infrastructure have been shown. These include first and second link status registers 110 and 210, first and second Adjacent Channel Power (ACP) controllers 120 and 220, and first and second user profiles 130 and 230. These components may be found in the controller, or may be located elsewhere in the network, such as in a networked database (not shown).

The first and second link status registers 110 and 210 are coupled to the base station 20 (if required, via the controller 30), and are arranged to contain information relating to the link status of the first and second mobile units 100 and 200 respectively. The link status reflects the type of transmission, i.e. signalling access, access attempt, speech access, low and high data rate traffic access, etc..

The first and second user profiles 130 and 230 contain information about the user of the first and second mobile units 100 and 200 respectively, and may also contain information about the nature of the mobile units. Such information may include the type of service required and/or paid for by the user, or the type of power amplifier incorporated in the mobile unit.

The first ACP controller 120 is coupled to receive inputs from the base station 20, the controller 30, the first link status register 110 and the first user profile 130. Similarly the second ACP controller 120 is coupled to receive inputs from the base station 20, the controller 30, the second link status register 210 and the second user profile 230. The first and second ACP controllers 120 and 220 also have outputs coupled to the base station 25, which will be further described below, together with the function of the ACP controllers 120 and 220 respectively.

In operation, communication may be established between the first mobile unit 100 and the base station 20 using a first channel 150, and between the second mobile unit 200 and the base station 25 using a second channel 250.

In order for the power amplifiers 105 and 205 to transmit substantially on only one selected channel, the power output must achieve a certain linearity. Due to the size and cost considerations in mobile station/unit design, this restricts significantly the design options for implementation of the RF power amplifiers.

In prior art communication systems, this issue was dealt with by defining for the system, a maximum allowed power leakage into adjacent channels due to spectral splattering of the output power, otherwise known as Adjacent Channel (Coupled) power (ACP). This ensured that only a certain amount of interference would be caused by mobiles communicating on the system, but it imposed a constraint on the manufacturers of the mobile units, requiring that the power amplifiers of each mobile be arranged so as to achieve the required linearity.

The power efficiency of a power amplifier is, generally speaking, inversely proportional to required linearity. Therefore a prior art system effectively imposed a maximum efficiency threshold for the power amplifiers of each mobile unit, by virtue of the fixed ACP value.

In the present invention, the first ACP controller 120 determines a first ACP value for the first mobile unit 100, for communicating on the first channel 150, and the second ACP controller 220 determines a second ACP value for the second mobile unit 200, for communicating on the second channel 250.

The first ACP value is determined by the first ACP controller 120 using one or more attributes to be further described below, and is sent via the base station 20 to the first mobile unit 100, which then adjusts its power amplifier accordingly.

Similarly, the second ACP value is determined by the second ACP controller 220 using one or more attributes to be further described below, and is sent via the base station 25 to the second mobile unit 200, which then adjusts its power amplifier accordingly.

The first and second ACP values may be transmitted on the first and second channels to the first and second mobile units 100 and 200, or via a broadcast message which is transmitted on a broadcast channel.

The attributes used to determine the value of the parameter are received from the inputs to the first and second ACP controllers 120 and 220. The inputs from the controller 30 may include static and dynamic attributes of the network. The static attributes may be dimensioning information and the network condition. This may include, where appropriate, the condition of another network (via a base station receiver emulator situated in the other network). The dynamic attributes may be network loading information, relating to current traffic conditions. When the network load is 100%, this will require drastic ACP values. When the network load is less than 20%, this will allow very relaxed ACP values.

The inputs to the first and second ACP controllers 120 and 220 from the link status registers 110 and 210 respectively contain link status information for first and second mobile units 100 and 200 respectively, including the status of the communication link, and the type of transmission.

The inputs to the first and second ACP controllers 120 and 220 from both the base stations 20 and 25 provide measurements derived from the mobile units 100 and 200, such as bit-error-rate, quality and power levels.

The inputs to the first and second ACP controllers 120 and 220 from the first and second user profiles 130 and 230 contain information regarding users of the first and second mobile units 100 and 200 respectively, such as preferred features, or subscription information.

The inputs from all of the above are then fed into the first and second ACP controllers 120 and 220 respectively, where they are processed according to an appropriate algorithm, and the first and second ACP values are determined. In this way information from the mobile units 100 and 200, from the network 10 and from the users determines the first and second ACP values.

In this way the first and second ACP values, which determine the allowed spectral splattering of output power, are set dynamically for each mobile unit. This allows the network 10 to have an influence on the power efficiency of the mobile units communicating within it.

For example, in an Frequency Division Multiplex Access (FDMA) system, the algorithm may determine that in low traffic conditions, where adjacent channels are not being used, the ACP value can be completely relaxed, such that mobile units can operate at a high power efficiency, with less linearity. Then when traffic increases, the ACP is tightened.

If one user has paid a higher subscription premium, then the algorithm could reflect this by offering a more relaxed ACP value to that user, perhaps by placing that user in a channel with empty adjacent channels. In this way the user who has paid a higher subscription will have a longer battery life, as the power amplifier within the mobile unit of the user can operate at a higher power efficiency.

In a further example, the algorithm may firstly determine, for a cell, background noise and co-channel interference from other cells, in order to fix power levels for the cell. Then the algorithm may set ACP values for the cell, such that the allowed ACP is at a level less than the background noise and co-channel interference. In this way the whole cell is optimised for power, avoiding the cascade of power mentioned above.

The first and second ACP values may contain absolute ACP values, or they may contain relative ACP values. In the case of the latter, the power level could be sent separately or at the same time as the ACP value.

Some mobile units may have a fixed power amplifier implementation, in which case either the communication protocol or the network 10 can have provision for determining that the ACP characteristic is not going to be observed in a mobile without the flexibility.

It may also be desirable to have default ACP value for low end users. The default value may be fixed by the standard. There may also be several default values according to the type of transmission and to the power level required for transmission.

It will be appreciated that alternative embodiments to the one described above are possible. For example, each of the first and second ACP values may contain a number of different values, corresponding to the allowed crosstalk firstly in adjacent channels, then in alternate channels (the channels neighbouring the adjacent channels), and then in further, more distant channels. Also, the invention may be implemented in a system wherein at least some of the portable devices comprise a terminal and a subscriber identity module. In such an arrangement, the user profiles may be stored in either the portable device or in the network.

Furthermore, the above system could be used in Code Division Multiplex Access (CDMA) or in Time Division Multiplex Access (TDMA), in which case the algorithm would contain the means to calculate average ACP effects from different channels within the same frequency.

## Claims

1. Apparatus for dynamically controlling adjacent channel Interference in a communications system (5) including a base station (25) and a portable communications device (200) having a transmitter and adapted to communicate with the base station (25), said apparatus including means (120) for monitoring system parameters (110,130) and **characterised by** means (120) for generating on optimum adjacent channel coupled power setting for the portable communication device (200) dependent upon the system parameters, and means (25) for transmitting to the portable communication device (200) an instruction to set an adjacent channel coupled power level in its transmitter to the generated optimum value.

2. Apparatus according to claim 1 in which said system parameters include at least one of the following;
(a) a profile (130) of the user of the portable communication device;
(b) the nature of the portable communication device (200);
(c) the status of the communication link between the base station (25) and the portable communication device (200);
(d) the loading of the communication system;
(e) the power level measurements derived from portable communication device (200);
(f) the quality measurements derived from the portable communication device (200).

3. Apparatus according to either preceding claim and adapted to ensure that the generated optimum adjacent channel coupled power setting is below the level of background noise and co-channel Interference.

4. A method for dynamically controlling adjacent channel interference in a communications system (5) including a base station (25) and a portable communication device (200) having a transmitter and adapted to communicate with the base station, said method including the steps of monitoring system parameters (110, 130) and **characterised by** the further steps of generating on optimum adjacent channel coupled power setting for the portable communication device (200) dependent upon the system parameters, and transmitting to the portable communication device (200) an instruction to set an adjacent channel coupled power level in its transmitter to the generated optimum value.

5. A method according to claim 4 in which said system parameters include at least one of the following;
(a) a profile (130) of the user of the portable communication device;
(b) the nature of the portable communication device (200)
(c) the status of the communication link between the base station (25) and the portable communication device (200);
(d) the loading of the communication system;
(e) the power level measurements derived from the portable communication device (200);
(f) the quality measurements derived from the portable communication device (200).

6. A portable communication device (200) having a transmitter and adapted to operate in a communications system (5), the device being **characterised by** means for receiving from a remote station (25) comprising the communication system (5) an instruction to set an adjacent channel coupled power level of its transmitter to a specified value dependant on communications system parameters, and means for setting the adjacent channel coupled power level of its transmitter at the specified value, thereby minimising adjacent channel interference in the communication system.

## Patentansprüche

1. Vorrichtung zum dynamischen Steuern von Nachbarkanalinterferenzen in einem Kommunikationssystem (5), das eine Basisstation (25) und eine tragbare Kommunikationseinrichtung (200) umfasst, die einen Sender aufweist und dazu ausgelegt ist, mit der Basisstation (25) zu kommunizieren, wobei die Vorrichtung Mittel (120) zum Überwachen von Systemparametern (110, 130) umfasst und
**dadurch gekennzeichnet ist, dass** sie Mittel (120) zum Erzeugen einer optimalen Nachbarkanal-Koppelleistungs-Einstellung für die tragbare Kommunikationseinrichtung (200) in Abhängigkeit von den Systemparametern, und Mittel (25) zum Übertragen, an die tragbare Kommunikationseinrichtung (200), einer Anweisung zum Einstellen eines Nachbarkanal-Koppelleistungs-Pegels in ihrem Sender auf den erzeugten optimalen Wert aufweist.

2. Vorrichtung nach Anspruch 1, wobei die Systemparameter umfassen:
(a) ein Profil (130) des Benutzers der tragbaren Kommunikationseinrichtung, und/oder
(b) die Eigenschaften der tragbaren Kommunikationseinrichtung (200), und/oder
(c) den Status der Kommunikationsverbindung zwischen der Basisstation (25) und der tragbaren Kommunikationseinrichtung (200), und/oder
(d) die Last des Kommunikationssystems, und/oder
(e) die Leistungspegelmessungen, die von einer tragbaren Kommunikationseinrichtung (200) abgeleitet sind, und/oder
(f) die Qualitätsmessungen, die von der tragbaren Kommunikationseinrichtung (200) abgeleitet sind.

3. Vorrichtung nach einem der vorhergehenden Ansprüche, die dazu ausgelegt ist, sicherzustellen, dass die erzeugte optimale Nachbarkanal-Koppelleistungs-Einstellung unterhalb des Hintergrundrauschenpegels und der Co-Kanal-Interferenz liegt.

4. Verfahren zum dynamischen Steuern von NachbarkanalInterferenzen in einem Kommunikationssystem (5), das eine Basisstation (25) und eine tragbare Kommunikationseinrichtung (200) umfasst, die einen Sender aufweist und dazu ausgelegt ist, mit der Basisstation zu kommunizieren, wobei das Verfahren die Schritte des Überwachens von Systemparametern (110, 130) umfasst und **dadurch gekennzeichnet ist, dass** es die weiteren Schritte des Erzeugens einer optimalen Nachbarkanal-Koppelleistungs-Einstellung für die tragbare Kommunikationseinrichtung (200) in Abhängigkeit von den Systemparametern, und des Übertragens, an die tragbare Kommunikationseinrichtung (200), einer Anweisung zum Einstellen eines Nachbarkanal-Koppelleistungs-Pegels in ihrem Sender auf den erzeugten optimalen Wert umfasst.

5. Verfahren nach Anspruch 4, wobei die Systemparameter umfassen:
(a) ein Profil (130) des Benutzer der tragbaren Kommunikationseinrichtung, und/oder
(b) die Eigenschaften der tragbaren Kommunikationseinrichtung (200), und/oder
(c) den Status der Kommunikationsverbindung zwischen der Basisstation (25) und der tragbaren Kommunikationseinrichtung (200), und/oder
(d) die Last des Kommunikationssystems, und/oder
(e) die Leistungspegelmessungen, die von der tragbaren Kommunikationseinrichtung (200) abgeleitet sind, und/oder
(f) die Qualitätsmessungen, die von der tragbaren Kommunikationseinrichtung (200) abgeleitet sind.

6. Tragbare Kommunikationseinrichtung (200), die einem Sender aufweist und dazu ausgelegt ist, in einem Kommunikationssystem (5) zu arbeiten, wobei die Einrichtung **dadurch gekennzeichnet ist, dass** sie Mittel zum Empfangen einer Anweisung von einer Fernstation (25) des Kommunikationssystems (5) zum Einstellen eines Nachbarkanal-Koppelleistungs-Pegels ihres Senders auf einen spezifizierten Wert, in Abhängigkeit von Kommunikationssystemparametern, und Mittel zum Einstellen des Nachbarkanal-Koppelleistungs-Pegels ihres Senders auf den spezifizierten Wert umfasst, wodurch die Nachbarkanal-Interferenz in dem Kommunikationssystem minimiert wird.

## Revendications

1. Appareil pour contrôler dynamiquement l'interférence entre canaux adjacents dans un système de communication (5) incluant une station de base (25) et un dispositif de communication portable (200) ayant un émetteur et adapté pour communiquer avec la station de base (25), ledit appareil incluant un moyen (120) pour surveiller des paramètres du système (110, 130) et **caractérisé par** un moyen (120) pour générer un réglage de puissance de couplage de canal adjacent optimum pour le dispositif de communication portable (200) en fonction des paramètres du système, et un moyen (25) pour transmettre au dispositif de communication portable (200) une instruction pour régler un niveau de puissance de couplage de canal adjacent dans son émetteur à la valeur optimum générée.

2. Appareil selon la revendication 1, dans lequel lesdits paramètres du système incluent au moins un des suivants :
(a) un profil (130) de l'utilisateur du dispositif de communication portable ;
(b) la nature du dispositif de communication portable (200) ;
(c) l'état de la liaison de communication entre la station de base (25) et le dispositif de communication portable (200) ;
(d) le chargement du système de communication ;
(e) les mesures du niveau de puissance dérivées du dispositif de communication portable (200) ;
(f) les mesures de la qualité dérivées du dispositif de communication portable (200).

3. Appareil selon l'une ou l'autre des revendications précédentes et adapté pour garantir que le réglage de puissance de couplage de canal adjacent optimum généré est en dessous du niveau de bruit de fond et de l'interférence co-canal.

4. Procédé pour contrôler dynamiquement l'interférence entre canaux adjacents dans un système de communication (5) incluant une station de base (25) et un dispositif de communication portable (200) ayant un émetteur et adapté pour communiquer avec la station de base (25), ledit procédé incluant les étapes consistant à surveiller des paramètres du système (110, 130) et **caractérisé par** les étapes supplémentaires consistant à générer un réglage de puissance de couplage de canal adjacent optimum pour le dispositif de communication portable (200) en fonction des paramètres du système, et transmettre au dispositif de communication portable (200) une instruction pour régler un niveau de puissance de couplage de canal adjacent dans son émetteur à la valeur optimum générée.

5. Procédé selon la revendication 4, dans lequel lesdits paramètres du système incluent au moins un des suivants :
(a) un profil (130) de l'utilisateur du dispositif de communication portable ;
(b) la nature du dispositif de communication portable (200) ;
(c) l'état de la liaison de communication entre la station de base (25) et le dispositif de communication portable (200) ;
(d) le chargement du système de communication ;
(e) les mesures du niveau de puissance dérivées du dispositif de communication portable (200) ;
(f) les mesures de la qualité dérivées du dispositif de communication portable (200).

6. Dispositif de communication portable (200) ayant un émetteur et adapté pour fonctionner dans un système de communication (5), le dispositif étant **caractérisé par** un moyen pour recevoir d'une station éloignée (25) comprenant le système de communication (5) une instruction pour régler un niveau de puissance de couplage de canal adjacent de son émetteur à une valeur spécifiée dépendant des paramètres du système de communication, et un moyen pour régler le niveau de puissance de couplage de canal adjacent de son émetteur à la valeur spécifiée, minimisant ainsi l'interférence entre canaux adjacents dans le système de communication.
